# EUROPEAN PATENT SPECIFICATION

(11) **EP 2 607 449 B1**
(45) Date of publication and mention of the grant of the patent: **02.04.2014**
(21) Application number: 12198271.4
(22) Date of filing: 19.12.2012
(51) Int. Cl.: C09K 11/77, H05B 33/12, H01L 33/50

(54) **Preparation of yttrium-cerium-aluminum garnet phosphor**
Herstellung von Yttrium-Cer-Aluminium-Granatphosphor
Préparation de phosphore grenat dopé à l'yttrium-cerium-aluminum

(30) Priority: 22.12.2011 JP 2011281387
(43) Date of publication of application: 26.06.2013
(73) Proprietor: Shin-Etsu Chemical Co., Ltd., Chiyoda-ku, Tokyo (JP)
(72) Inventor: WATAYA, Kazuhiro, Echizen-shi, Fukui (JP); TSUKATANI, Toshihiko, Echizen-shi, Fukui (JP); KAWAZOE, Hirofumi, Echizen-shi, Fukui (JP)
(74) Representative: Stoner, Gerard Patrick

(56) References cited:
- EP-A1- 0 936 682
- WO-A1-2011/063028
- WO-A1-2011/097137
- WO-A2-2009/102727
- KR-A- 20080 075 972

## Description

### TECHNICAL FIELD

This invention relates to methods for preparing yttrium-cerium-aluminum garnet (sometimes referred to as YAG:Ce) phosphor, useful for converting or modifying the wavelength of light from a light-emitting element, and more particularly to a method for preparing a particulate YAG:Ce phosphor suited for constructing white light-emitting diodes.

### BACKGROUND

Light-emitting diodes (LEDs) are the most efficient among currently available light sources. In particular, white LEDs find a rapidly expanding share in the market as the next-generation light source to replace incandescent lamps, fluorescent lamps, cold cathode fluorescent lamps (CCFL), and halogen lamps. The white LEDs are arrived at by combining a blue LED with a phosphor capable of emission upon blue light excitation. Typically, green or yellow phosphors are combined with blue LEDs to produce pseudo-white light. Suitable phosphors include Y₃Al₅O₁₂ : Ce, (Y, Gd)₃(Al, Ga)₅O₁₂ : Ce, (Y, Gd)₃Al₅O₁₂ : Ce, Tb₃Al₅O₁₂ : Ce, CaGa₂S₄ : Eu, (Sr, Ca, Ba)₂SiO₄ : Eu, and Ca-α-SiAlON : Eu.

Among these, the Y₃Al₅O₁₂ : Ce phosphor is most often used because it has a high emission efficiency upon blue light excitation. It is prepared, as disclosed in JP 3700502, for example, by dissolving rare earth elements Y and Ce in a proper stoichiometric ratio in an acid, coprecipitating the solution with oxalic acid, firing the coprecipitate into coprecipitate oxide, mixing it with aluminum oxide, and adding a fluoride (e.g., ammonium fluoride or barium fluoride) as flux thereto. The mixture is placed in a crucible and fired in air at 1,400°C for 3 hours. The fired material is wet milled in a ball mill, washed, separated, dried, and finally sieved.

When a phosphor is synthesized by such a conventional method involving mixing of raw material particles and solid-phase reaction at high temperature, the phosphor is generally composed of elements in a certain range of composition. The element serving as the luminescent center is incorporated in the crystal to an extent that is governed by the lattice size of the crystal. That is, if the ionic radius of the element serving as the luminescent center is larger than the ionic radius of the element to be substituted thereby, the element as the luminescent center is incorporated in the crystal during growth only in a certain compositional range. In the typical example of Y₃Al₅O₁₂ : Ce phosphor described in JP 3700502, Ce³⁺ ion to be introduced has a greater ionic radius than Y³⁺ ion to be substituted thereby. Then, the prior art method involving melting the raw material powder in a high-temperature atmosphere and inducing crystal growth is difficult to introduce a more than predetermined amount of Ce³⁺ ion into crystals because Ce³⁺ ion tends to refrain from entering Y₃Al₅O₁₂ crystals in the course of crystal growth. In fact, when phosphor particles obtained from crystal growth by this method are analyzed for the distribution of elements, it is seen that although the phosphor is prepared from the raw material containing a relatively high concentration of Ce element, the Ce concentration in the phosphor (garnet phase) is lower than the Ce concentration in the raw material.

As the Ce content of Y₃Al₅O₁₂ : Ce phosphor increases, the emission color shifts to the longer wavelength side. However, when the phosphor is prepared by the prior art method, an upper limit is imposed on the Ce content in the phosphor for the above reason. Then the attempt to increase the concentration of Ce for shifting the emission wavelength of YAG phosphor to the longer wavelength side encounters a certain limit.

Meanwhile, there is a demand for white LEDs having a relatively low color temperature because such LED can find a variety of applications as the warm-color illuminating device.

As alluded to previously, the white LED is generally constructed by using a green or yellow phosphor for converting part of the emission of a blue LED to produce white light. Sometimes, a red phosphor is additionally used to construct a warm-color white LED having improved color rendering and lower color temperature. However, the use of a red phosphor means that two or more different phosphors are used in combination, which can cause a chromaticity variation to the white LED. Thus the combination of blue LED with YAG phosphor is the first choice.

While the white LED producing pseudo-white is constructed by combining blue LED with yellow phosphor, it is desired from the goal of warm-color LED having low color temperature that the emission color of Y₃Al₅O₁₂ : Ce phosphor be of longer wavelength. However, as pointed out above, the prior art synthesis method imposes a certain limit to the attempt to increase the concentration of Ce for shifting the emission wavelength of YAG phosphor to the longer wavelength side. It is thus difficult to obtain a Y₃Al₅O₁₂ : Ce phosphor suited for warm-color LED.

### Citation List

Patent Document 1: JP 3700502

### THE INVENTION

An aim herein is to provide new and useful methods for preparing yttrium-cerium-aluminum garnet (YAG:Ce) phosphors, particularly with a view to enhancing the effective incorporation of Ce therein, whereby preferably the phosphors are suited for constructing warm-color white LEDs.

The inventors have found that by providing a raw material in which the concentration of cerium is 4 mol% to 15 mol% based on the sum of yttrium and cerium, and a molar ratio of aluminum to the sum of yttrium and cerium,
[Al/(Y+Ce)], is 5/3 to 5.5/3, granulating the raw material into particles with an average particle size of 5 to 100 µm, melting the particles in a plasma of suitable high temperature and heat-treating the resulting particles in a non-oxidizing atmosphere for crystallization, there are obtained YAG:Ce phosphor particles suited for constructing warm-color white LED. Specifically, the prior art YAG:Ce phosphor produces emission color having a x value of 0.42 at maximum on the xy chromaticity coordinates when excited with 450 nm radiation, whereas YAG:Ce phosphors obtainable by the inventive method can have a high x value of 0.47 or more.

The invention provides a method for preparing a yttrium-cerium-aluminum garnet phosphor comprising the steps of combining yttrium, cerium and aluminum compounds to form a raw material in which the concentration of cerium is 4 mol% to 15 mol% based on the sum of yttrium and cerium, and a molar ratio of aluminum to the sum of yttrium and cerium is from 5/3 to 5.5/3; granulating the raw material into particles with an average particle size of 5 to 100 µm; melting the particles in a high-temperature plasma; and heat treating the resulting particles in a non-oxidizing atmosphere for crystallization.

The heat treating step is typically at a temperature of 900° C to 1,700°C.

In the raw material, the concentration of cerium is preferably 4 mol% to 10 mol% based on the sum of yttrium and cerium. The phosphor product is an aspect of the invention, as is the processing of the product by use in a light-emitting device e.g. in combination with another phosphor as described.

### ADVANTAGEOUS EFFECTS

We find that the method proposed herein is capable of producing a YAG:Ce phosphor having an x value of at least 0.47, sufficient to construct warm-color white LEDs. Such YAG:Ce phosphor, when combined with a light-emitting element having an emission wavelength of 400 to 470 nm, is capable of producing white light having a low color temperature. A warm-color illuminating device can be manufactured from such a combination.

### BRIEF DESCRIPTION OF DRAWINGS

FIG. 1 is a cross-sectional view of an exemplary light-emitting device using a phosphor of the invention,
FIG. 2 is an electron micrograph showing the outer appearance of phosphor particles in Example 1.
FIG. 3 is a diagram showing the result of XRD analysis of phosphor particles in Example 1.
FIG. 4 is an electron micrograph showing the outer appearance of phosphor particles in Comparative Example 1.

### FURTHER EXPLANATIONS; OPTIONS AND PREFERENCES

As used herein, the term "phosphor" refers to a fluorescent substance. The terms "particles" and "powder" are equivalent in that the powder is a grouping of particles.

YAG:Ce phosphor obtainable by the present method desirably produces emission color having x value at least 0.47, especially 0.47 to 0.54 on the xy chromaticity coordinates when excited with 450 nm light. Preferably the phosphor consists of a garnet phase, that is, is free of another phase. More preferably the YAG:Ce phosphor is free of elements other than Y, Al, Ce and O as its constituent elements. A method for preparing such YAG:Ce phosphor involves the steps of combining yttrium, cerium and aluminum compounds to form a raw material in which the concentration of cerium is 4 mol% to 15 mol% based on the sum of yttrium and cerium, and a molar ratio of aluminum to the sum of yttrium and cerium is 5/3 to 5.5/3, granulating the raw material into particles with an average particle size of 5 to 100 µm, melting the particles in a high-temperature plasma, and heat treating the resulting particles in a non-oxidizing atmosphere for crystallization.

The raw material for the phosphor is a mixture of yttrium, cerium and aluminum compounds which include oxides, hydroxides, carbonates, mineral acid salts, halides, and organic acid salts. Since the final phosphor is oxide, it is preferable to use oxides and hydroxides. The raw material is in particulate form which preferably has as small a particle size as possible from the standpoint of obtaining phosphor particles of uniform composition. The compounds as the raw material may have average particle size not greater than 1 µm. Yttrium, cerium and aluminum compounds are combined so as to provide a cerium concentration of 4 to 15 mol% based on the sum of yttrium and cerium. At the same time, a molar ratio of aluminum to the sum of yttrium and cerium is 5/3 to 5.5/3. The raw material which is a mixture of yttrium, cerium and aluminum compounds is granulated into particles with an average particle size of 5 to 100 µm, preferably 10 to 65 µm. Granulation techniques include spray drying, spray pyrolysis, and tumbling granulation. A proper technique may be selected depending on the particle size of the raw material (or mixture) and the final phosphor.

It is noted that the average particle size may be measured by a particle size distribution measuring system based on laser light diffractometry, as a weight average value D₅₀, that is, a particle size corresponding to a cumulative weight of 50% (also referred to as median diameter).

Prior to granulation, an organic binder such as polyacrylic acid salt, carboxymethyl cellulose, polycarboxylic acid, methyl cellulose, or polyvinyl alcohol may be added to the raw material for helping the resulting particles retain their shape. The organic binder which will be completely removed during subsequent firing is preferred. The organic binder is not particularly limited as long as it helps the resulting particles retain their shape and it is free of a metallic component which cannot be removed and adversely affects phosphor characteristics. After granulation, the particles may be classified using a sieve, for the purpose of eventually producing phosphor particles having a narrow distribution of particle size.

The granulated powder may be fired at a high temperature for the purposes of removing the binder and increasing the strength thereof. Firing is preferably carried out in air, nitrogen, argon or a reducing atmosphere. The firing temperature may vary with the particle size of the granulated powder, the type of organic binder, and the atmosphere, it is typically 500 to 1,700°C, preferably 800 to 1,650°C, and more preferably 1,200 to 1,620°C. Temperatures below 500°C are insufficient to burn out the binder and to increase the strength of the granulated powder whereas temperatures above 1,700°C may cause the particles to be fused together and make it difficult to keep the particles having an average particle size of 5 to 100 µm as such.

Next, the particles having said average particle size are melted using plasma to provide high temperature. The plasma system used herein may be any well-known one, for example, a radio-frequency induction thermal plasma system as long as it can produce a plasma having a center temperature of at least 2,000°C. At the plasma center temperature of at least 2,000°C, preferably at least 3,000°C, the particles are melted. The plasma center temperature is usually up to 10,000°C although the upper limit is not critical.

The particles pass through the plasma where they are melted at the plasma center temperature e.g. at least 2,000°C, and emerge from the plasma whereupon they rapidly cool and re-solidify to spherical particles. Such plasma heating is known per se. The resulting spherical particle sizes substantially correspond to those of the particles fed. That is, spherical particles having an average particle size of 5 to 100 µm are recovered. The spherical particles thus recovered are less crystalline or are amorphous.

Next the spherical particles are crystallized by heat treatment in a high-temperature atmosphere. This results in spherical particles of yttrium-cerium-aluminum garnet phosphor with improved crystallinity. Prior to the heat treatment in high-temperature atmosphere, cerium is substantially uniformly distributed in the particle interior. Even after the amorphous spherical particles are converted to highly crystalline YAG:Ce garnet phosphor particles by the heat treatment in high-temperature atmosphere, substantially the entirety of cerium is retained within the phosphor particles.

The temperature of crystallization heat treatment should preferably be 900 to 1,700°C, more preferably 1,200 to 1,650°C, and even more preferably 1,400 to 1,600°C. Temperatures below 900°C are insufficient to promote crystal growth in particles, resulting in a phosphor having a low emission efficiency. Temperatures above 1,700°C cause particles to be fused together, resulting in a marked loss of the yield of a phosphor particle fraction having an average particle size of 5 to 100 µm. The heat treatment atmosphere should be a non-oxidizing or reducing atmosphere. Heat treatment is preferably carried out in an atmosphere of argon or nitrogen in admixture with hydrogen, for example. In this way, the phosphor is obtained in spherical particle form, which may be further classified into a desired average particle size.

On X-ray diffraction (XRD) analysis, the phosphor thus obtained is identified to be yttrium-cerium-aluminum garnet. For example, the phosphor is represented by the compositional formula (1):

YₐCe_{b}Al_{c}O_{d} (1)

wherein 0.04 ≤ b/(a+b) ≤ 0.15, a+b=3, 5.0 ≤ c ≤ 5.5, and 12 ≤ d ≤ 12.75.

Specifically, the cerium concentration is controlled to 4 to 15 mol%, preferably 4 to 10 mol% based on the sum of yttrium and cerium. The chromaticity of emission color of the phosphor can be adjusted by changing the cerium concentration. As the cerium concentration increases from 4 mol% to 15 mol%, the x value of chromaticity increases. When excited with 450 nm light, the phosphor produces emission color having a x value of at least 0.47, specifically 0.47 to 0.54 on the xy chromaticity coordinates. It is noted that the resulting phosphor is free of a phase other than the garnet phase, for example, an alumina phase. As used herein, the term "cerium concentration" refers to a percentage of cerium molar concentration relative to the sum of yttrium molar concentration and cerium molar concentration, that is, [Ce/(Y+Ce)]×100 mol%.

Aspects of the invention include a method for preparing a yttrium-cerium-aluminum garnet phosphor having an emission color which cannot be achieved by the prior art method, the phosphor prepared thereby, and a light-emitting device using the phosphor. In the case of phosphors synthesized by the prior art solid phase reaction method, their emission color changes little when the cerium concentration exceeds 4 mol%. For those phosphors prepared under such conditions to provide a cerium concentration of less than 4 mol%, the emission color shifts to the longer wavelength side as the cerium concentration increases, and specifically, the x value becomes 0.46 when the cerium concentration reaches 4 mol%. However, even if the cerium concentration is further increased, the x value of emission color no longer increases. The reason is as follows. The solid phase reaction method of synthesizing yttrium-aluminum garnet from yttrium-cerium coprecipitated oxide and aluminum oxide as the raw material has the tendency that cerium having a large ionic radius is difficultly taken into the phosphor crystal during crystal growth. It is difficult to incorporate cerium beyond a certain level. Even if the concentration of cerium having a large ionic radius in the raw material is significantly increased, the concentration of cerium in the phosphor product cannot be increased beyond the level.

By contrast, the method for preparing a yttrium-cerium-aluminum garnet phosphor according to the invention starts with a raw material in the form of a mixture of yttrium, cerium and aluminum compounds, which becomes an amorphous yttrium/cerium/aluminum/oxygen mixture in the course. This permits cerium to be contained in particles in a higher concentration than in the prior art method. According to the invention, the amorphous mixed oxide having a high cerium concentration is heat treated to induce crystal growth under such conditions that the existing cerium may be retained in the phosphor rather than being expelled out. Then the inventive method can prepare a yttrium-cerium-aluminum garnet phosphor having an emission color which cannot be achieved by the prior art method. The phosphor produces emission color having a x value of at least 0.47, specifically 0.47 to 0.54.

A further aspect of the invention is a light-emitting device comprising the YAG:Ce phosphor prepared as above and a light-emitting element for emitting light having a wavelength of 400 to 470 nm. They are coupled such that at least part of the light from the light-emitting element is wavelength converted (e.g., converted to yellow light) by the YAG:Ce phosphor. The particulate phosphor of the invention is suited for converting the wavelength of light from a light-emitting element to construct a light-emitting diode. The particulate phosphor of the invention is advantageously used in a light-emitting diode, and an illuminating device or backlight device or the like may be fabricated therefrom. Using the phosphor for wavelength conversion of part of light from blue LED, a warm-color white LED device which is not achievable with the prior art YAG:Ce garnet phosphor can be manufactured.

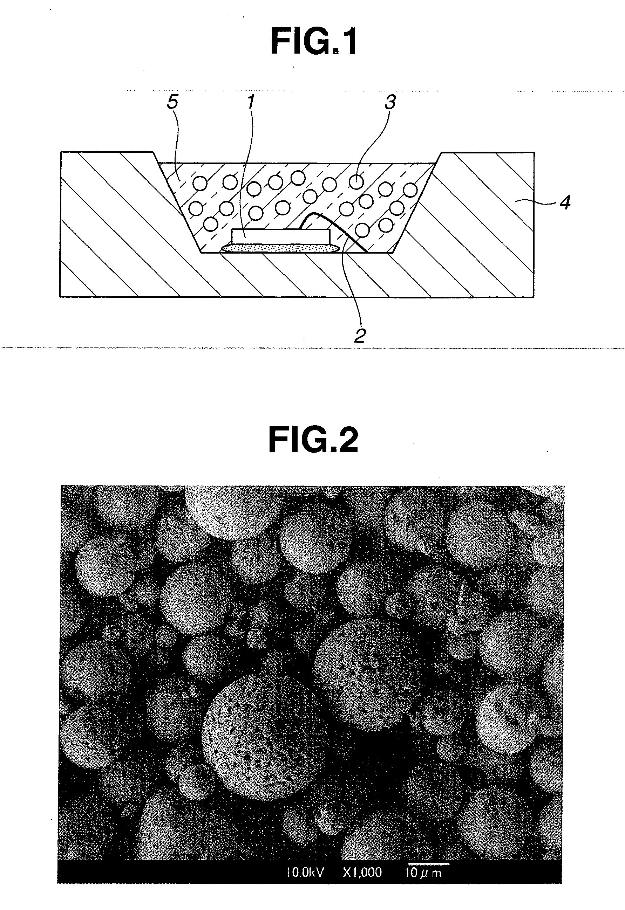

FIG. 1 schematically illustrates one exemplary light-emitting device. The device includes a light-emitting element 1 which is typically a blue LED chip for emitting light having a peak wavelength of 400 to 470 nm, and an encapsulant 5 formed of a silicone resin. Dispersed in the resin encapsulant 5 are particles 3 of the YAG:Ce phosphor for converting the wavelength of part of light from the light-emitting element 1 to a different wavelength. A conductive wire 2 is bonded to the element 1. The element 1 and encapsulant 5 are received in a package 4.

### EXAMPLE

Examples are given below by way of illustration and not by way of limitation.

### Example 1

A yttrium oxide powder having a purity of 99.9 wt% and an average particle size of 1.0 µm, an aluminum oxide powder having a purity of 99.9 wt% and an average particle size of 0.5 µm, and a cerium oxide powder having a purity of 99.9 wt% and an average particle size of 0.2 µm were mixed to form 1,000 g of a powder mixture having a molar ratio of Y/Al/Ce = 2.85/5.00/0.15. The powder mixture was combined with 1,500 g of deionized water, 10 g of ammonium polyacrylate, and 2 g of carboxymethyl cellulose, and milled in a ball mill for 6 hours. Using a two-fluid nozzle, the resulting slurry was granulated into particles having an average particle size of 15 µm. The particles were heat treated in air at 1,000°C for 2 hours to burn out the organic matter.

An RF induction thermal plasma system was used. The particles were passed through the argon plasma where they were melted and then solidified, obtaining spherical particles. On qualitative analysis by X-ray diffractometer (XRD), the spherical particles were found to be amorphous composite.

The spherical particles were heat treated in 1% hydrogen-containing argon gas at 1,350°C for 5 hours, yielding phosphor particles. FIG. 2 is a micrograph of the phosphor particles observed under an electron microscope.

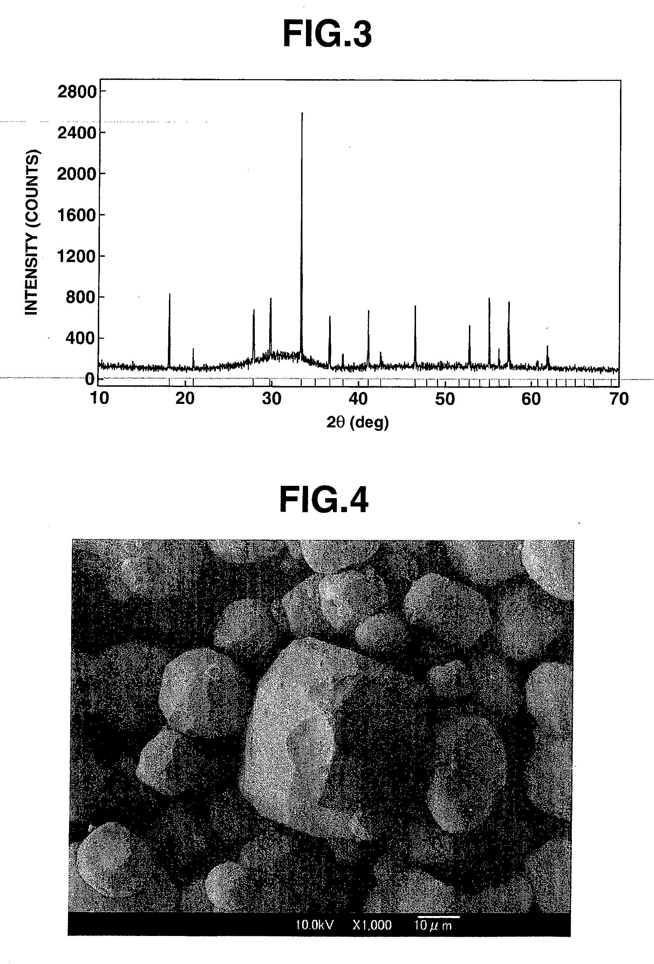

On XRD analysis of the phosphor particles, the main phase showed peaks in full conformity to the diffraction peaks of yttrium-aluminum garnet phase as shown in FIG. 3 and was thus identified to be garnet phase. A phase other than garnet phase, for example, alumina phase was not observed.

When excited with 450 nm light (i.e., light having a peak at wavelength 450 nm), the phosphor particles emitted light whose chromaticity had x = 0.485 on the xy chromaticity coordinates as measured by chromaticity measuring system Model QE1100 (Otsuka Electronics Co., Ltd.).

### Comparative Example 1

A yttrium oxide powder having a purity of 99.9 wt% and an average particle size of 1.0 µm, an aluminum oxide powder having a purity of 99.9 wt% and an average particle size of 3.0 µm, and a cerium oxide powder having a purity of 99.9 wt% and an average particle size of 0.2 µm were mixed to form 1,000 g of a powder mixture having a molar ratio of Y/Al/Ce = 2.85/5.00/0.15. To the powder mixture was added 200 g of barium fluoride as flux. After thorough mixing, the mixture was placed in an alumina crucible and heat treated in an atmosphere of 2% hydrogen and 98% argon at 1,400°C for 4 hours. The fired product was washed with water, separated and dried, obtaining phosphor particles.

The phosphor particles were observed under an electron microscope. As seen from the photomicrograph of FIG. 4, the particles were polyhedral, with crystal faces perceived.

On XRD analysis of the phosphor particles, the main phase showed peaks in full conformity to the diffraction peaks of yttrium-aluminum garnet phase and was thus identified to be garnet phase. Phases other than garnet phase, for example, BaCeOF₃ phase were observed.

When excited with 450 nm light, the phosphor particles emitted light whose chromaticity had x = 0.460 on the xy chromaticity coordinates.

Table 1 tabulates the components and evaluation results of Example 1 and Comparative Example 1. A comparison of Example 1 with Comparative Example 1 shows that Example 1 had a greater x value on the xy chromaticity coordinates, despite the same cerium concentration ([Ce/(Y+Ce)]×100 mol%).

**Table 1**

| | Molar ratio | | | Ce/(Y+Ce) (mol%) | x value | Phase other than garnet phase |
|---|---|---|---|---|---|---|
| | yttrium | aluminum | cerium | | | |
| Example 1 | 2.85 | 5.00 | 0.15 | 5 | 0.485 | nil |
| Comparative Example 1 | 2.85 | 5.00 | 0.15 | 5 | 0.460 | found |

| | | | | | | |
|---|---|---|---|---|---|---|
| * Molar ratio of Comparative Example 1 is a ratio of compounds charged. | | | | | | |

### Examples 2 to 5 and Reference Examples 1 to 3

A yttrium oxide powder having a purity of 99.9 wt% and an average particle size of 1.0 µm, an aluminum oxide powder having a purity of 99.9 wt% and an average particle size of 0.5 µm, and a cerium oxide powder having a purity of 99.9 wt% and an average particle size of 0.2 µm were mixed to form 1,000 g of powder mixtures so that the molar ratio of aluminum to the total of yttrium and cerium was 5.5/3 and the cerium concentration ([Ce/(Y+Ce)]×100) was 2, 2.5, 3, 4, 7, 10, and 15 mol%. Each powder mixture was combined with 1,500 g of deionized water, 10 g of ammonium polyacrylate, and 2 g of carboxymethyl cellulose, and milled in a ball mill for 6 hours. Using a spray drier, the resulting slurry was granulated into particles having an average particle size of 20 µm. The particles were heat treated in air at 1,000°C for 2 hours to burn out the organic matter.

An RF induction thermal plasma system was used. The particles were passed through the argon plasma where they were melted and then solidified, obtaining spherical particles. On qualitative analysis by XRD, the spherical particles were found to be amorphous composite.

The spherical particles were heat treated in 1% hydrogen-containing argon gas at 1,500°C for 4 hours, yielding 7 groups of phosphor particles.

On XRD analysis of all the phosphor particles, the main phase showed peaks in full conformity to the diffraction peaks of yttrium-aluminum garnet phase and was thus identified to be garnet phase. A phase other than garnet phase, for example, alumina phase was not observed.

The chromaticity of light from the phosphor particles upon excitation with 450 nm light was measured, finding that the x value on the xy chromaticity coordinates increased as the cerium concentration increased.

### Comparative Examples 2 to 6

A yttrium oxide powder having a purity of 99.9 wt% and an average particle size of 1.0 µm, an aluminum oxide powder having a purity of 99.9 wt% and an average particle size of 0.5 µm, and a cerium oxide powder having a purity of 99.9 wt% and an average particle size of 0.2 µm were mixed to form 1,000 g of powder mixtures so that the molar ratio of aluminum to the total of yttrium and cerium was 5.5/3 and the cerium concentration ([Ce/(Y+Ce)]×100) was 2, 3, 4, 7, and 10 mol%. To each powder mixture was added 200 g of barium fluoride as flux. After thorough mixing, the mixture was placed in an alumina crucible and heat treated in an atmosphere of 2% hydrogen and 98% argon at 1,400°C for 4 hours. The fired product was washed with water, separated and dried, obtaining phosphor particles.

On observation under an electron microscope, the phosphor particles were polyhedral, with crystal faces perceived.

On XRD analysis of the phosphor particles, the main phase showed peaks in full conformity to the diffraction peaks of yttrium-aluminum garnet phase and was thus identified to be garnet phase. Phases other than garnet phase, for example, BaCeOF₃ phase were observed.

The chromaticity of light from the phosphor particles upon excitation with 450 nm light was measured, finding that the x value on the xy chromaticity coordinates increased as the cerium concentration increased up to 4 mol%. However, the x value increased little further when the cerium concentration exceeded 4 mol%.

Table 2 tabulates the components and evaluation results of Examples 2 to 5, Reference Examples 1 to 3 and Comparative Examples 2 to 6. In respect of Reference Examples 1 to 3 and Comparative Examples 2 and 3 where the cerium concentration ([Ce/(Y+Ce)]×100) is less than 4 mol%, Reference Examples 1 to 3 showed slightly greater x values. In respect of Examples 2 to 5 and Comparative Examples 4 to 6 where the cerium concentration ([Ce/(Y+Ce)]×100) is equal to or more than 4 mol%, Examples 2 to 5 showed greater x values.

**Table 2**

| | | Ce/(Y+Ce) (mol%) | x value | Phase other than garnet phase |
|---|---|---|---|---|
| Reference Example | 1 | 2 | 0.446 | nil |
| | 2 | 2.5 | 0.455 | nil |
| | 3 | 3 | 0.461 | nil |
| Example | 2 | 4 | 0.474 | nil |
| | 3 | 7 | 0.501 | nil |
| | 4 | 10 | 0.510 | nil |
| | 5 | 15 | 0.532 | nil |
| Comparative Example | 2 | 2 | 0.442 | found |
| | 3 | 3 | 0.459 | found |
| | 4 | 4 | 0.464 | found |
| | 5 | 7 | 0.465 | found |
| | 6 | 10 | 0.462 | found |

### Notes

In respect of numerical ranges disclosed in the present description it will of course be understood that in the normal way the technical criterion for the upper limit is different from the technical criterion for the lower limit, i.e. the upper and lower limits are intrinsically distinct proposals.

For the avoidance of doubt it is confirmed that in the general description above, in the usual way the proposal of general preferences and options in respect of different features of the method and product obtainable thereby constitutes the proposal of general combinations of those general preferences and options for the different features, insofar as they are combinable and compatible and are put forward in the same context.

## Claims

1. A method of preparing an yttrium-cerium-aluminum garnet phosphor comprising the steps of:
combining yttrium, cerium and aluminum compounds to form a raw material in which cerium is present in a concentration of 4 mol% to 15 mol% based on the sum of yttrium and cerium, and a molar ratio of aluminum to the sum of yttrium and cerium is from 5/3 to 5.5/3,
granulating the raw material to form particles with an average particle size of 5 to 100 µm,
melting the particles in a plasma, and
heat treating the resulting particles in a non-oxidizing atmosphere for crystallization.

2. A method of claim 1 wherein the heat treating step is at a temperature of 900°C to 1,700°C.

3. A method of claim 1 or 2 wherein in the raw material,
the concentration of cerium is 4 mol% to 10 mol% based on the sum of yttrium and cerium.

4. A method of any one of the preceding claims wherein the particles are passed through said plasma which has a center temperature of at least 2,000°C for said melting, and emerging from the plasma re-solidify to spherical particles with an average particle size of 5 to 100 µm.

5. A method of any one of the preceding claims wherein the resulting yttrium-cerium-aluminum garnet phosphor consists of the garnet phase.

6. A method of any one of the preceding claims wherein the resulting yttrium-cerium-aluminum garnet phosphor has an emission color with an x value of at least 0.47 when excited with 450 nm light.

7. Yttrium-cerium-aluminum garnet phosphor obtainable by a method of any one of claims 1 to 6.

## Patentansprüche

1. Verfahren zur Herstellung eines Yttrium-Cer-Aluminiumgranat-Luminophors, umfassend die folgenden Schritte:
Vereinigen von Yttrium-, Cer- und Aluminiumverbindungen zur Bildung eines Rohmaterials, in dem Cer in einer Konzentration von 4 Mol-% bis 15 Mol-%, bezogen auf die Summe aus Yttrium und Cer, vorhanden ist und das Molverhältnis von Aluminium und der Summe aus Yttrium und Cer von 5:3 bis 5,5:3 beträgt,
Granulieren des Rohmaterials zur Bildung von Teilchen mit einer mittleren Teilchengröße von 5 bis 100 µm,
Schmelzen der Teilchen in einem Plasma und
Wärmebehandlung der resultierenden Teilchen in einer nichtoxidierenden Atmosphäre zur Kristallisierung.

2. Verfahren nach Anspruch 1, worin der Schritt der Wärmebehandlung bei einer Temperatur von 900 °C bis 1700 °C erfolgt.

3. Verfahren nach Anspruch 1 oder 2, worin in dem Rohmaterial die Konzentration von Cer 4 Mol-% bis 10 Mol-%, bezogen auf die Summe aus Yttrium und Cer, beträgt.

4. Verfahren nach einem der vorangegangenen Ansprüche, worin die Teilchen das Plasma passieren, das eine Kerntemperatur von zumindest 2000 °C für das Schmelzen aufweist, und worin sich die Teilchen nach Verlassen des Plasmas erneut zu kugelförmigen Teilchen mit einer mittleren Teilchengröße von 5 bis 100 µm verfestigen.

5. Verfahren nach einem der vorangegangenen Ansprüche, worin der resultierende Yttrium-Cer-Aluminiumgranat-Luminophor aus der Granatphase besteht.

6. Verfahren nach einem der vorangegangenen Ansprüche, worin der resultierende Yttrium-Cer-Aluminiumgranat-Luminophor eine Emissionsfarbe mit einem x-Wert von zumindest 0,47 aufweist, wenn er mit Licht mit 450 nm angeregt wird.

7. Yttrium-Cer-Aluminiumgranat-Luminophor, der durch ein Verfahren nach einem der Ansprüche 1 bis 6 erhalten werden kann.

## Revendications

1. Procédé pour préparer un luminophore grenat à base d'yttrium-cérium-aluminium, comprenant les étapes consistant à:
combiner des composés de l'yttrium, du cérium et de l'aluminium pour former une matière première dans laquelle le cérium est présent à une concentration de 4 % en moles à 15 % en moles par rapport à la somme de l'yttrium et du cérium, le rapport molaire de l'aluminium à la somme de l'yttrium et du cérium étant de 5/3 à 5,5/3,
granuler la matière première pour former des particules ayant une granulométrie moyenne de 5 à 100 µm,
fondre les particules dans un plasma, et
traiter à la chaleur les particules résultantes dans une atmosphère non oxydante pour réaliser une cristallisation.

2. Procédé selon la revendication 1, dans lequel l'étape de traitement à la chaleur est à une température de 900°C à 1700°C.

3. Procédé selon la revendication 1 ou 2, dans lequel, dans la matière première, la concentration du cérium est de 4 % en moles à 10 % en moles par rapport à la somme de l'yttrium et du cérium.

4. Procédé selon l'une quelconque des revendications précédentes, dans lequel les particules passent dans ledit plasma qui a une température centrale d'au moins 2000°C pour ladite fusion, et à la sortie du plasma elles se re-solidifient en particules sphériques ayant une granulométrie moyenne de 5 à 100 µm.

5. Procédé selon l'une quelconque des revendications précédentes, dans lequel le luminophore grenat à base d'yttrium-cérium-aluminium résultant est constitué de la phase grenat.

6. Procédé selon l'une quelconque des revendications précédentes, dans lequel le luminophore grenat à base d'yttrium-cérium-aluminium résultant a une couleur d'émission avec une valeur x d'au moins 0,47 quand il est excité avec une lumière à 450 nm.

7. Luminophore grenat à base d'yttrium-cérium-aluminium pouvant être obtenu par un procédé selon l'une quelconque des revendications 1 à 6.
